(19) Europäisches Patentamt
European Patent Office
Office européen des brevets

(11) **EP 2 560 208 B1**

(12) **EUROPÄISCHE PATENTSCHRIFT**

(45) Veröffentlichungstag und Bekanntmachung des Hinweises auf die Patenterteilung:
**21.02.2018   Patentblatt 2018/08**

(51) Int Cl.:
*H01L 31/02* *(2006.01)*          *H01L 31/0216* *(2014.01)*

(21) Anmeldenummer: **12005259.2**

(22) Anmeldetag: **18.07.2012**

(54) **Optoelektronischer Sensor**

Optoelectronic sensor

Capteur optoélectronique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.08.2011   EP 11006694**

(43) Veröffentlichungstag der Anmeldung:
**20.02.2013   Patentblatt 2013/08**

(73) Patentinhaber: **Balluff GmbH**
**73765 Neuhausen a.d.F. (DE)**

(72) Erfinder:
• **Bronner, Manuel**
**72760 Reutlingen (DE)**

• **Hilsenbeck, Stefan**
**73770 Denkendorf (DE)**

(74) Vertreter: **Jakelski & Althoff**
**Patentanwälte PartG mbB**
**Patentanwälte**
**Partnerschaftsgesellschaft**
**Mollenbachstraße 37**
**71229 Leonberg (DE)**

(56) Entgegenhaltungen:
**DE-T2- 69 803 044          US-A1- 2002 051 068**
**US-A1- 2008 283 948       US-A1- 2009 065 884**
**US-B1- 6 285 832             US-B1- 6 624 899**

EP 2 560 208 B1

**Beschreibung**

Die vorliegende Erfindung betrifft einen optoelektronischen Sensor. Weiterhin betrifft die vorliegende Erfindung eine Sensorvorrichtung, die den erfindungsgemäßen optoelektronischen Sensor umfasst. Außerdem betrifft die Erfindung ein Verfahren zur Positionsbestimmung eines Objektes mittels der erfindungsgemäßen Sensorvorrichtung. Schließlich betrifft die Erfindung ein Computerprogramm, das alle Schritte des erfindungsgemäßen Verfahrens nach Anspruch, wenn es auf einem Rechengerät abläuft.

Stand der Technik

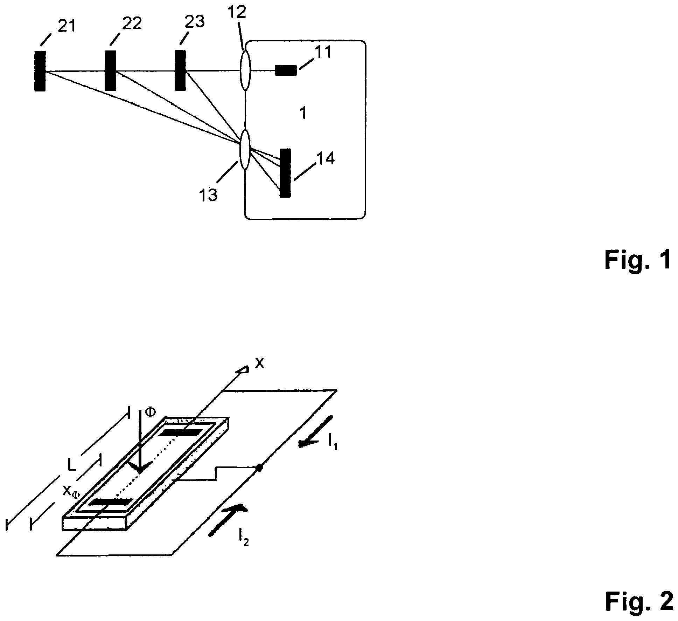

Lichttaster mit Hintergrundausblendung (HGA), welche als optoelektronische Industriesensorvorrichtungen eingesetzt werden, arbeiten nach dem Triangulationsverfahren. Ein solcher Lichttaster 1 ist in Fig. 1 dargestellt. Eine Laserdiode 11, welche als Sender fungiert, emittiert Licht und beleuchtet ein Objekt im Erfassungsbereich des Lichttasters 1 mittels einer Sendelinse 12. Die Lichtstrahlen werden vom Objekt diffus zum Lichttaster 1 zurückreflektiert und von einer Empfangslinse 13 auf ein PSD-Element (Position-Sensitive-Device) 14 fokussiert. Je nach Abstand des Objekts 21, 22, 23 treffen die Lichtstrahlen unter einem anderen Winkel auf die Empfangslinse 13, was sich im "Wandern" des Schwerpunktes des so erzeugten Lichtreflexes (laterale Lichtverteilung) auf dem PSD-Element 14 bemerkbar macht. Ein solches Triangulationsverfahren wird auch in Kameras verwendet, wie sie beispielsweise in der US 6,285,832 B1 beschrieben werden.

Die DE 698 03 044 T2 beschreibt ein optisches Gerät zur kontaktlosen Messung des Abstandes zu einer Lichtquelle, das alternativ zu Triangulationssystemen eingesetzt werden kann, um große Entfernungen zu messen, bei denen Schattenbereiche vernachlässigbar sind.

Ein PSD ist in Fig. 2 dargestellt. Es besteht aus einer an zwei gegenüberliegenden Seiten kontaktierten Deckelektrode einer großflächigen Fotodiode. Die Deckelektrode besitzt einen vergleichsweise hohen einheitlichen Flächenwiderstand. Die Diode wird punktförmig belichtet. Im Bereich der Belichtung $\Phi$ entsteht ein Fotostrom, der je nach Lichtposition in einem bestimmten Verhältnis über die an den Rändern liegenden Kontaktierungen abfließt. Aus den Strömen $I_1$ und $I_2$ kann die Position $x_\Phi$) der Belichtung entlang der Längsachse x des PSDs aus folgender Formel berechnet werden:

$$x_\Phi = \frac{I_1}{I_1 + I_2} * L$$

L gibt hierbei die Länge des PSD-Elements an.

Oberflächenbereiche des PSD-Elements, welche nicht in seiner optischen Detektionsebene liegen, können durch eine Abdeckung vor einfallendem Licht geschützt werden, um Fehler bei der Detektion zu minimieren. Diese können dadurch entstehen, dass Halbleiterelemente des PSD-Elements auch außerhalb der Detektionsebene eine Photosensibilität aufweisen und somit auf den Einfall von Streulicht reagieren. Beispielsweise beschreibt die US 2002/0051068 A1, lineare Bildsensoren eines Photokopierers mit einer lichtabschirmenden Schicht zu bedecken, welche Transferelektroden an der Sensoroberfläche vor Lichteinfall schützt. Die US 2009/0065884 A1 beschreibt CCD-Elemente (Charge-Coupled Device), in denen oberflächlich angeordnete Leiterpfade von einer lichtundurchlässigen Schicht bedeckt sind. Die US 2008/0283948 A1 beschreibt eine Photodiode auf deren Oberfläche Pixel jeweils von einer lichtundurchlässigen Schicht umgeben sind.

Üblicherweise verstärkt eine dem PSD-Element nachgeschaltete elektronische Verstärkerschaltung die beiden Querströme $I_1$ und $I_2$ und gibt sie an einen Mikrocontroller weiter, in dem sie logisch verarbeitet werden können. Beim Triangulationsverfahren wird die Lage des Lichtfokuspunktes auf dem PSD ausgewertet und nicht die Amplitude des aus der reflektierten Strahlung resultierenden Fotostroms. Daher ist das Abstandssignal in der Theorie unabhängig von den Reflexionseigenschaften des Objektes.

Dies wird durch die sogenannte Grauwertverschiebung beschrieben. Hierbei handelt es sich um die Abstandsdifferenz des Sensorschaltpunktes bei einer Einstellung mit unterschiedlichen Objektreflektivitäten. Mit einer Normmessplatte wird der Sensor auf einen Abstand eingestellt. Mit einer anderen Normmessplatte wird der damit erreichte Abstand gemessen. Die Differenz dieser beiden Schaltpunkte in % wird als Grauwertverschiebung bezeichnet. Je kleiner die Grauwertverschiebung desto farbunabhängiger arbeitet der Sensor. Die Grauwertverschiebung des Lichttasters geht also theoretisch gegen Null. In der Realität ist die Abstandsauswertung trotzdem von der Empfangsenergie abhängig und diese beeinflusst wiederum die Grauwertverschiebung des Sensor, welche typischerweise bis zu 10% betragen kann.

Im Stand der Technik wurden nun verschiedene Möglichkeiten vorgeschlagen, den so erzeugten Dynamikbereich einzuschränken. Zum einen ist eine Intensitätsregelung des Senders (d.h. der Laserdiode) möglich. Allerdings führt dies dazu, dass der Lichtfleck bei unterschiedlichen Abständen unterschiedlich hell ist. Außerdem ist zur Intensitätsregelung des Senders eine aufwendige Elektronik notwendig. Weiterhin wurde eine mehrstufige Verstärkerschaltung vorgeschlagen. Dies führt allerdings beim Wechseln der Verstärkung zu Unstetigkeitsstellen und es wird ebenfalls eine aufwendige Elektronik benötigt.

Es wurde auch vorgeschlagen, vor dem PSD ein lasergeschnittenes oder -geätztes Metallblech zu positionieren, welches als optische Blende (Aperturblende) fungiert, um die Lichtenergie im Nahbereich zu begrenzen und den Dynamikbereich einzuengen. Jedoch treten bei der Serienfertigung derartiger Bauteile, bedingt durch Fertigungstoleranzen, Produktionsstreuungen der Mechanikbauteile auf. Dies führt dazu, dass die Blende und das PSD in ihrer Lage zueinander beispielsweise um bis zu 0,2 mm verschoben sein können, Außerdem können die optischen Linsen des Lichttasters den Lichtfokuspunkt an einer leicht abweichenden Position erzeugen. Dadurch kann es vorkommen, dass die Blende in Bereichen wirkt, an denen ein maximaler Energiedurchsatz nötig wäre, um einen maximalen Schaltabstand des Sensors zu erreichen, beispielsweise im Fernbereich. Als Folge sinkt die Empfangsenergie, die Grauwertverschiebung steigt, der Sensor muss empfindlich abgelichtet werden oder es kommt zu erhöhten Fertigungsausschuss.

Auch war es bisher herstellungs- und konstruktionsbedingt unmöglich, die Blende so zu gestalten, dass sie über den Objektabstand einen quasi linearen Energieverlauf erzeugt. In der Praxis wird dadurch im Nahbereich die Energie derart begrenzt, dass die Blindzone des Sensors steigt bzw. Objekte mit schwacher Reflektivität nicht erkannt werden. Dies wirkt vor allem bei energetischen Lichttastern als störend.

Aufgabe der vorliegenden Erfindung ist es nun, einen optoelektronischen Sensor bereitzustellen, der den Dynamikbereich einschränkt, ohne dass es bei der Serienproduktion derartiger Sensoren zu Fertigungsausschuss kommt und ohne dass eine aufwendige Elektronik notwendig ist.

Offenbarunq der Erfindung

Diese Aufgabe wird erfindungsgemäß durch einen optoelektronischen Sensor gelöst, bei dem auf der Oberfläche des Empfangsbauteils in der optischen Detektionsebene mindestens eine erste Schicht aufgebracht ist, die als optisch wirksame Blende ausgebildet ist. Unter einer Blende wird erfindungsgemäß jede für sichtbares Licht undurchlässige Schicht mit einer Öffnung verstanden, welche die Ausdehnung von Strahlenbündeln begrenzt. Indem die Blende direkt auf der Oberfläche des optoelektronischen Sensors aufgebracht ist, kann sie schon im Herstellungsprozess des Sensors als Schicht aufgebracht werden, die als optische Blende wirkt. Wenn es sich bei dem optoelektronischen Sensor um ein PSD handelt, wird diese Schicht beispielsweise direkt auf das Silizium des PSDs aufgebracht. Hierdurch werden gegenüber einem bekannten optoelektronischen Sensor mit separater Blende weniger Bauteile benötigt, da die separate Metallblende und ein zu deren Befestigung benötigter Fixierrahmen entfallen. Es ist ein geringerer Fertigungsaufwand notwendig, und es kommt auch zu geringerem Fertigungsausschuss, da keine Toleranzen zwischen Blende und Sensor möglich sind. Dies führt im Ergebnis zu geringeren Herstellungskosten. Unter der optischen Detektionsebene wird insbesondere ein Oberflächenbereich des optoelektronischen Sensors verstanden, der ausschließlich zur Generierung eines Fotostroms eingerichtet ist.

Es ist erfindungsgemäß bevorzugt, dass es sich bei der ersten Schicht um eine Metallschicht handelt, welche durch ein Metallisierungsverfahren auf den optoelektronischen Sensor aufgebracht werden kann. Als Metall wird erfindungsgemäß insbesondere Aluminium verwendet. Dieses kann beispielsweise mit einem in der Halbleitertechnik bekannten Lithographieverfahren auf die Oberfläche des optoelektronischen Sensors aufgebracht werden. Die erste Schicht hat insbesondere eine Dicke im Bereich von 100 nm bis 150 nm. Durch Metallisierung sind hohe Freiheitsgrade in der Ausgestaltung der Blende möglich. Während bei der Verwendung eines lasergeschnittenen oder - geätzten Metallbleches als Blende gemäß dem Stand der Technik nur Strukturbreiten der Blende von mehr als 0,2 mm möglich sind, ermöglicht die Verwendung einer Metallisierungsschicht auch die Herstellung von Blenden mit einer Strukturbreite von 0,2 mm oder weniger. Unter der Strukturbreite wird erfindungsgemäß die kleinstmögliche geometrisch nutzbare Anordnung der Blende verstanden.

Die Blende ist als Punktefeld mit lateral zunehmender oder abnehmender Dichte ausgebildet. Als Punktefeld wird erfindungsgemäß ein Gitter oder eine Matrix aus beschichteten Bereichen auf dem optoelektronischen Sensor verstanden. Insbesondere handelt es sich bei dem Punktefeld um eine Punktmatrix.

Viele herkömmliche optoelektronische Sensorvorrichtungen erfordern ein Element in der Optik, welches Fremdlicht, d. h. Lichtanteile, die nicht vom Sender der Sensorvorrichtung emittiert werden, blockiert. Hierbei kann es sich beispielsweise um Sonnenlicht oder um Licht von Leuchtstoffröhren handeln. Typischerweise umfassen optoelektronische Sensorvorrichtungen einen Sender, der rotes Licht ($\lambda = 650 \pm 20$ nm) aussendet. In diesem Fall wird der Blauanteil des Lichtes ($\lambda = 200 - 630$ nm) durch Rotfärbung der Empfangslinse der optoelektronischen Sensorvorrichtung blockiert bzw. geschwächt. Weiterhin wird ein optischer Filter in die Sensorvorrichtung eingebaut, um den infraroten Anteil des Lichtes ($\lambda_2 \geq 670$ nm) zu blockieren bzw. zu schwächen. Erfindungsgemäß ist es nun möglich, auch auf dieses separate Bauteil zu verzichten und Infrarotlicht direkt am optoelektronischen Sensor zu blockieren. In einer bevorzugten Ausführungsform der Erfindung ist hierzu auf den optoelektronischen Sensor mindestens eine zweite Schicht aufgebracht, die für Licht in einem bestimmten Bereich des optischen Spektrums, insbesondere für Licht mit einer Wellenlänge von $\lambda \geq 670$ nm, undurchlässig ist. Es ist erfindungsgemäß besonders bevorzugt, dass diese zweite Schicht sowohl Licht im Wellenlängenbereich $\lambda = 200 - 630$ nm als auch im Wellenlängenbereich $\lambda \geq 670$ nm absorbiert. Dies ermöglicht es, nicht nur auf einen separaten Infrarotblocker zu verzichten, sondern macht auch die Einfärbung der Empfangslinse überflüssig. Die zweite Schicht besteht erfindungsgemäß insbesondere aus mehreren Teilschichten und kann durch abwechselndes Aufbringen von hochbrechenden und niedrigbrechenden Teilschichten hergestellt werden, beispielsweise mittels Sputtern oder Molekularstrahlepitaxie (MBE). Diese Teilschichten können beispielsweise aus Silber oder aus Aluminium bestehen. Die Dicke jeder Teilschicht liegt insbesondere im Bereich von λ/4 bis λ/2 des zu absorbierenden Lichtes. In einer anderen bevorzugten Ausführungsform der Erfindung weist der optoelektronischen Sensor auf der ersten Schicht mindestens einen Glaswafer bzw. eine Glasscheibe auf. Dieser Glaswafer ist ebenfalls in der Lage, Licht in einem bestimmten Bereich des optischen Spektrums zu blockieren. Wenn der optoelektronische Sensor zur Verwendung in einer Sensorvorrichtung vorgesehen ist, die einen Sensor aufweist, welcher Licht im Infrarotbereich (z.B. A = 850 nm) emittiert, wird der bestimmte Bereich des optischen Spektrums, welcher von der zweiten Schicht bzw. vom Glaswafer blockiert wird, entsprechend der Wellenlänge des vom Sender ausgesandten Lichtes angepasst.

Bei dem optoelektronischen Sensor handelt es sich insbesondere um einen Sensor, mit dem eine laterale Verschiebung des Lichtintensitätsschwerpunkts auf dem optoelektronischen Sensor gemessen werden kann. Es kann sich bei dem optoelektronischen Sensor um jeden bekannten Sensortyp handeln, insbesondere jedoch um ein PSD-Element, eine CCD-Zeile oder eine Fotodiode.

Die vorliegende Erfindung betrifft weiterhin eine Sensorvorrichtung, die eine Lichtquelle und den optoelektronischen Sensor gemäß der Erfindung umfasst. Bei dieser Sensorvorrichtung handelt es sich insbesondere um einen Lichttaster, eine Reflexionslichtschranke, einen Laufzeitsensor oder einen Farbsensor. Vor der Lichtquelle und vor dem optoelektronischen Sensor ist bevorzugt jeweils eine Linse zur Fokussierung der ausgesandten bzw. der einfallenden Lichtstrahlen angeordnet.

Als Lichtquelle wird bevorzugt eine Lichtquelle gewählt, welche üblicherweise in optoelektronischen Sensorvorrichtungen Verwendung findet. Hierbei handelt es sich insbesondere um eine Leuchtdiode, eine Laserdiode oder einen Laser.

Bevorzugt weist die Sensorvorrichtung ein Einstellelement auf, das eingerichtet ist, um den Schaltpunkt des optoelektronischen Sensors auf ein Objekt zu justieren. Dies ermöglicht eine einfache Anpassung der Sensorvorrichtung an unterschiedliche Bedingungen. Bei dem Einstellelement kann es sich beispielsweise um ein Potentiometer, ein Teach-In oder eine Einstellung über externe Leitungen handeln.

Weiterhin ist es bevorzugt, dass die Sensorrichtung mit einer Verstärkerschaltung verbunden ist, die eine konstante oder eine stetige Verstärkung bewirkt. Insbesondere handelt es sich bei der Verstärkerschaltung um eine einstufige Verstärkerschaltung. Hierdurch kommt es zu keinen Unstetigkeitsstellen, wenn die Verstärkung wechselt.

Ein Verfahren zur Positionserkennung eines Objektes, umfasst das Aussenden von Licht mittels der Lichtquelle der Sensorvorrichtung, das Detektieren der lateralen Position eines von dem Objekt reflektierten Lichtstrahls mittels des optoelektronischen Sensors der Sensorvorrichtung, und das Berechnen des Abstandes zwischen der Sensorvorrichtung und dem Objekt aus der lateralen Position des reflektierten Lichtstrahls. Das erfindungsgemäße Computerprogramm führt alle Schritte dieses Verfahrens aus, wenn es auf einem Rechengerät abläuft.

Kurze Beschreibung der Zeichnungen

Ausführungsbeispiele der Erfindung sind in den Zeichnungen dargestellt und in der nachfolgenden Beschreibung näher erläutert.

Fig. 1    zeigt eine Sensorvorrichtung gemäß dem Stand der Technik;

Fig. 2    zeigt schematisch den Aufbau eines PSD gemäß dem Stand der Technik;

Fig. 3    zeigt eine Sensorvorrichtung gemäß dem Stand der Technik;

Fig. 4    zeigt eine Sensorvorrichtung gemäß einer Ausführungsform der vorliegenden Erfindung;

Fig. 5    zeigt eine isometrische Darstellung eines optoelektronischen Sensors gemäß einer Ausführungsform der Erfindung;

Fig. 6    zeigt ein Diagramm der Energieverteilung an einem PSD ohne Einschränkung des Dynamikbereiches;

Fig. 7    zeigt ein Diagramm der Energieverteilung an einem PSD, welches mit einem lasergeschnittenen Metallblech als optische Blende ausgestattet ist;

Fig. 8    zeigt ein Diagramm der Energieverteilung an einem PSD, welches mit einer Metallschicht versehen ist, die eine schlitzförmige Blende aufweist;

Fig. 9    zeigt ein Diagramm der Energieverteilung an einem PSD, welches eine Metallschicht mit einer stegförmigen Blende aufweist;

Fig. 10    zeigt ein Diagramm der Energieverteilung an einem PSD, welches eine Metallschicht in Form einer Punktmatrix aufweist.

Ausführungsformen der Erfindung

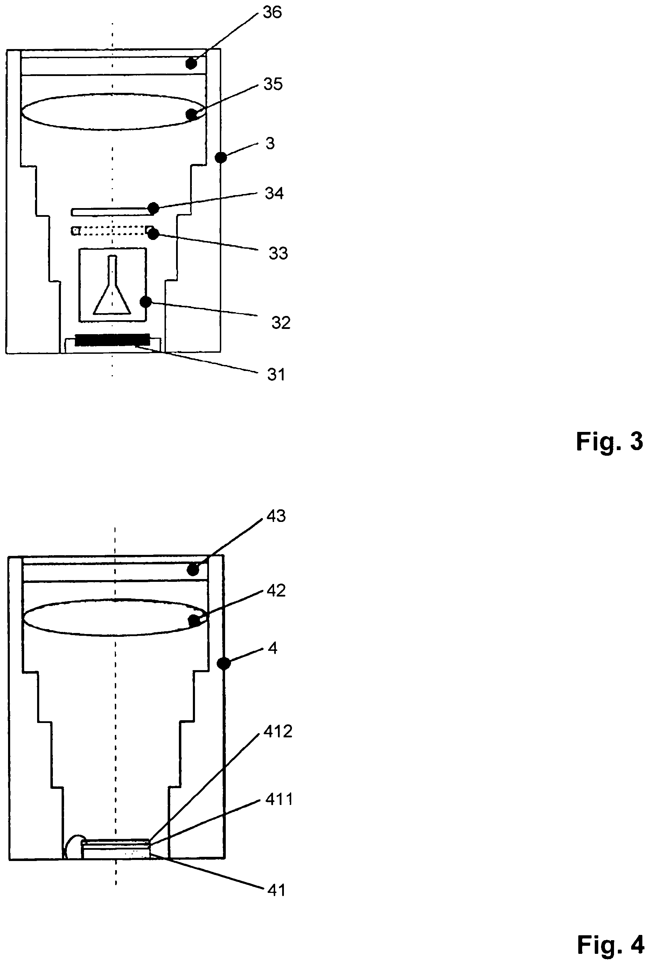

Fig. 3 zeigt das Empfangsteil 3 einer optoelektronischen Sensorvorrichtung gemäß dem Stand der Technik. Vor einem PSD 31 ist ein lasergeschnittenes Metallblech als Blende 32 positioniert. Dieses dient zur Einschränkung des Dynamikbereichs des PSDs 31. Vor der Blende 32 befindet sich ein Fixierrahmen 33 zur Aufnahme der Blende 32. Vor dem Fixierrahmen 33 ist ein IR-Blocker 34 angeordnet. Vor dem IR-Blocker 34 sind eine rotgefärbte Linse 35 und die Frontscheibe 36 des Empfangsteils 3 der Sensorvorrichtung angeordnet.

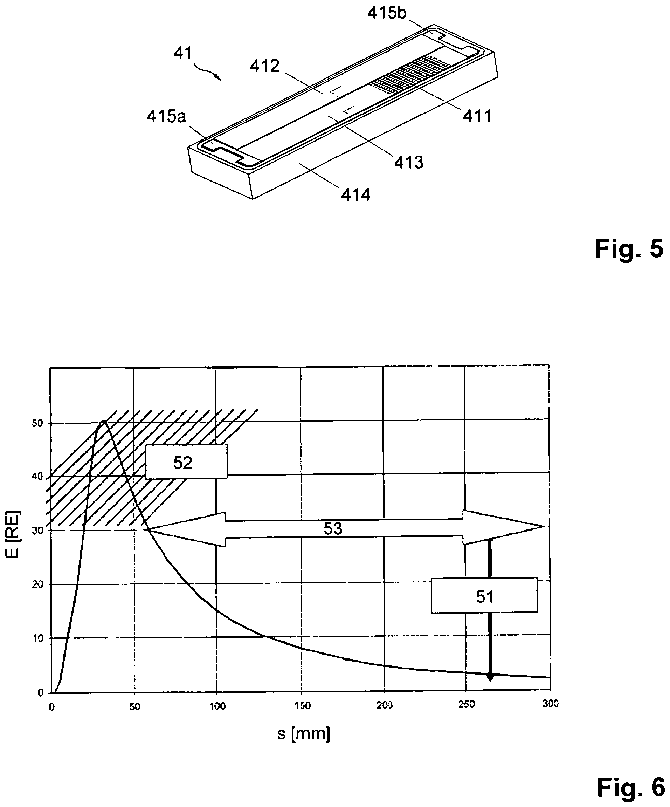

Fig. 4 zeigt eine Ausführungform des Empfangsteils 4 einer Sensorvorrichtung gemäß der vorliegenden Erfindung. Als optoelektronischer Sensor wird ein PSD 41 eingesetzt, welches eine aktive Fläche von 3,5 x 1 mm$^2$ aufweist, und eine mittels Metallisierung aufgetragene Metallschicht als Blende 411 aufweist. Weiterhin weist es eine zweite Schicht 412 auf, die für Licht mit der Wellenlänge im Bereich von 200 bis 630 nm und von größer oder gleich 670 nm undurchlässig ist. Daher kann auf eine zusätzliche Blende, einen Fixierrahmen und einen IR-Blocker verzichtet werden. Das Empfangsteil 4 weist weiterhin nur noch eine Linse 42 und eine Frontscheibe 43 auf. Die Linse 42 muss nicht rot eingefärbt sein. Dieses Empfangsteil kann mit einer Laserdiode (emittierte Wellenlänge $\lambda$ = 650 nm) als Sender zu einem Lichttaster gemäß Fig. 1 kombiniert werden. Eine isometrische Darstellung des PSDs 41 ist in Fig. 5 gezeigt. Eine Metallschicht 411 in Form einer Punktmatrix ist auf einem lichtempfindlichen Bereich 413 aufgebracht, welcher als optische Detektionsebene fungiert. Die optische Detektionsebene, welche der aktiven Fläche des PSDs 41 entspricht, dient ausschließlich zur Generierung eines Fotostroms, wenn sie mit Licht bestrahlt wird. Der lichtempfindliche Bereich 413 ist auf einem Substrat 414 angeordnet und wird an seinen beiden schmaleren Kanten durch elektrische Kontaktflächen 415a, 415b begrenzt. Die zweite Schicht 412, welche die erste Schicht 411 und den lichtempfindlichen Bereich bedeckt, ist in Fig. 5 zur besseren Veranschaulichung in einer Teilschnittdarstellung abgebildet, in welcher die Hälfte der zweiten Schicht 412 entfernt wurde.

Fig. 6 zeigt die Energieverteilung an einem PSD, welches über keine Blende verfügt. Die Energie E des einfallenden Lichts am PSD wird in relativen Einheiten RE gegen den Abstand s in Millimetern des Objekts vom PSD aufgetragen. Der Dynamikbereich 51 eines herkömmlichen Verstärkers beträgt 30 relative Lichtintensitätseinheiten RE. Daher wird der Verstärker bei einer Energie E von mehr als 30 relativen Einheiten im Bereich 52 übersteuert. Nur der Bereich 53 mit einer Energie von weniger als 30 relativen Einheiten, d.h. ab einem Objektabstand s von 60 mm zum PSD, ist als Erfassungsbereich nutzbar.

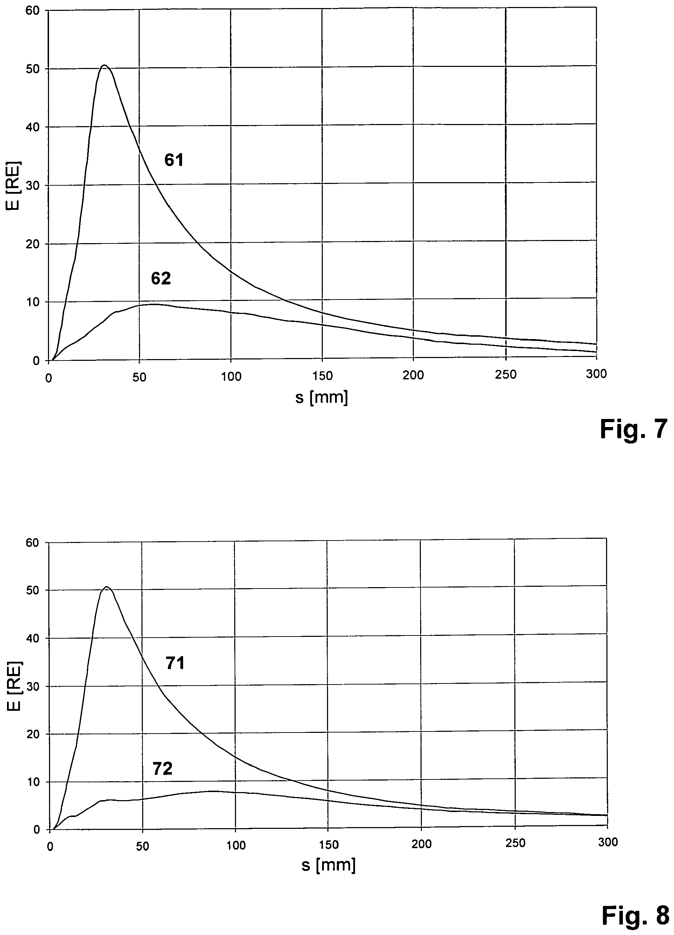

Fig. 7 zeigt, wie sich der Energieverlauf am PSD ändert, wenn eine herkömmliche Blende gemäß Fig. 3 verwendet wird. Dem Energieverlauf 61 ohne Blende wird der Energieverlauf 62 mit Blende gegenübergestellt. Es ist zu erkennen, dass nun eine Übersteuerung des Verstärkers verhindert wird, da die Lichtenergie E stets unter 30 relativen Einheiten liegt. Da die Blende konstruktionsbedingt in einem Abstand vor dem PSD angeordnet ist, reduziert sie allerdings auch die Lichtenergie im Fernbereich. Daher sinkt die Reichweite des Sensors. Der Fernbereich beginnt in Fig. 6 bei einem Objektabstand s von 150 mm.

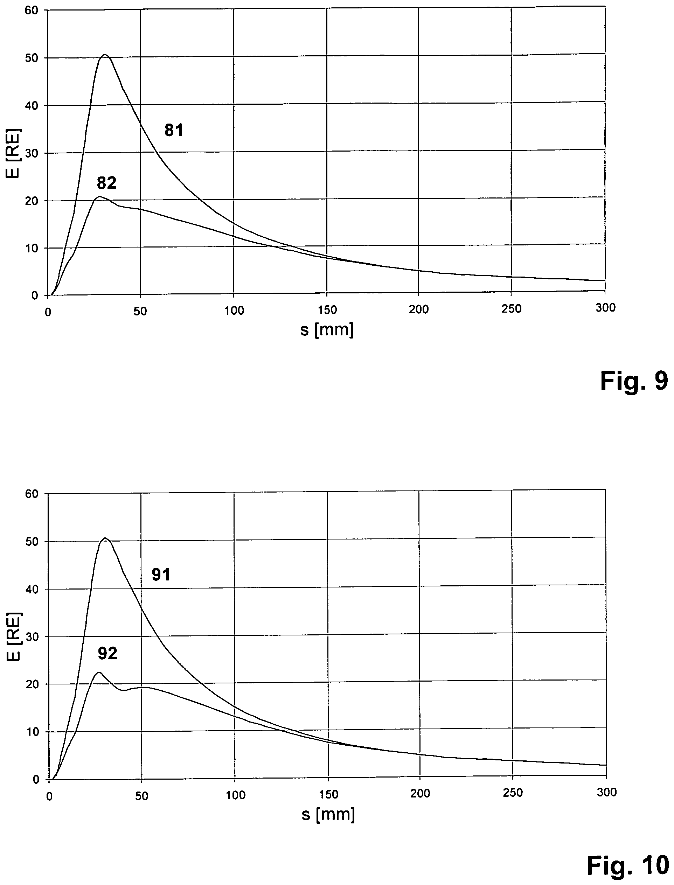

Fig. 8 zeigt den Energieverlauf am PSD bei Verwendung einer Metallisierungsschicht als Blende, welche einen Schlitz mit einer Strukturbreite von 100 $\mu$m an der engsten Stelle des Schlitzes aufweist. Dem Energieverlauf 71 ohne Blende wird der Energieverlauf 72 mit Blende gegenübergestellt. Es ist zu erkennen, dass die Energie E auf weniger als 30 relative Einheiten verringert wird, ohne dass es zu einer Beschneidung der Energie E im Fernbereich kommt. Fig. 9 zeigt den Energieverlauf an einem PSD, welches mit einer Metallisierungsschicht versehen ist, die die Form eines 500 $\mu$m breiten Steges aufweist. Dem Energieverlauf 81 ohne Blende wird der Energieverlauf 82 mit Blende gegenübergestellt. Auch hier wird eine Übersteuerung des Verstärkers ausgeschlossen. Fig. 10 zeigt den Energieverlauf an einem PSD, welches eine erfindungsgemäß besonders bevorzugte Metallisierungsschicht aufweist, die als Punktefeld ausgebildet ist. Die Punkte bedecken jeweils eine Fläche von 15 x 15 $\mu$m$^2$. Die Dichte des Punktefeldes nimmt über eine Wegstrecke von 2 mm gleichmäßig von null bis zu einer Dichte von 4.000 Punkten pro mm$^2$ zu. Damit bleiben ca. 200 Punkte pro mm$^2$ lichtdurchlässig. Dies entspricht einer Abnahme der Lichttransmission von 100% auf 5%. Dem Energieverlauf 91 ohne Blende wird der Energieverlauf 92 mit Blende gegenübergestellt. Hier bleibt die Energie E am PSD ebenfalls bei jedem Objektabstand unter 30 relativen Einheiten. Eine Reduzierung der Energie im Fernbereich tritt nicht auf.

Die erfindungsgemäße Sensorvorrichtung, welche den erfindungsgemäßen optoelektronischen Sensor enthält, ist nahezu toleranzunempfindlich. Sie ist universell einsetzbar und unabhängig von der Lichtverteilung. Weiterhin treten keine Doppelschaltpunkte auf, da es keine scharfen Konturkanten gibt, an denen das Lichtsignal abgeschaltet wird.

**Patentansprüche**

1. Optoelektronischer Sensor (41), worin auf der Oberfläche des Empfangsbauteils in der optischen Detektionsebene mindestens eine erste Schicht (411) aufgebracht ist, die als optisch wirksame Blende ausgebildet ist, **dadurch gekennzeichnet, dass** die Blende als Punktefeld mit lateral zunehmender oder abnehmender Dichte ausgebildet ist.

2. Optoelektronischer Sensor nach Anspruch 1, **dadurch gekennzeichnet, dass** die optische Detektionsebene ein Oberflächenbereich des optoelektronischen Sensors ist, der ausschließlich zur Generierung eines Fotostroms eingerichtet ist.

3. Optoelektronischer Sensor nach Anspruch 1 oder 2, **dadurch gekennzeichnet, dass** es sich bei der ersten Schicht (411) um eine Metallschicht handelt, welche mittels eines Metallisierungsverfahrens auf den optoelektronischen Sensor (41) aufgebracht ist.

4. Optoelektronischer Sensor nach Anspruch 3, **dadurch gekennzeichnet, dass** die Blende eine Strukturbreite von maximal 0,2 mm aufweist.

**5.** Optoelektronischer Sensor nach einem der Ansprüche 1 bis 4, **dadurch gekennzeichnet, dass** auf der mindestens einen ersten Schicht (411) mindestens eine zweite Schicht (412) angeordnet ist, die für Licht mit einer Wellenlänge in einem bestimmten Bereich des optischen Spektrums undurchlässig ist.

**6.** Optoelektronischer Sensor nach einem der Ansprüche 1 bis 4, **dadurch gekennzeichnet, dass** auf der mindestens einen ersten Schicht mindestens ein Glaswafer angeordnet ist.

**7.** Optoelektronischer Sensor nach einem der Ansprüche 1 bis 6, **dadurch gekennzeichnet, dass** es sich bei dem optoelektronischen Sensor (41) um einen Sensor handelt, der eine laterale Verschiebung des Intensitätsschwerpunkts von auf den optischen Positionssensor einfallendem Licht detektiert wobei der optoelektronischer Sensor insbesondere ausgewählt ist aus der Gruppe, bestehend aus einem PSD-Element, einer CCD-Zeile, und einer Photodiode.

**8.** Sensorvorrichtung, umfassend eine Lichtquelle und einen optoelektronischen Sensor (41) nach einem der Ansprüche 1 bis 7.

**9.** Sensorvorrichtung nach Anspruch 8, **dadurch gekennzeichnet, dass** die Sensorvorrichtung ausgewählt ist aus der Gruppe, bestehend aus einem Lichttaster, einer Reflexlichtschranke, einem Laufzeitsensor und einem Farbsensor.

**10.** Sensorvorrichtung nach Anspruch 8 oder 9, **dadurch gekennzeichnet, dass** die Lichtquelle ausgewählt ist aus der Gruppe, bestehend aus einer Leuchtdiode, einer Laserdiode und einem Laser.

**11.** Sensorvorrichtung nach einem der Ansprüche 8 bis 10, **dadurch gekennzeichnet, dass** sie ein Einstellelement umfasst, das eingerichtet ist, um den Schaltpunkt des optoelektronischen Sensors auf ein Objekt zu justieren.

**12.** Sensorvorrichtung nach einem der Ansprüche 8 bis 10, **dadurch gekennzeichnet, dass** der optoelektronische Sensor (41) mit einer Verstärkerschaltung verbunden ist, die eine konstante Verstärkung oder eine stetige Verstärkung bewirkt.

**13.** Verfahren zur Positionserkennung eines Objektes, umfassend

    - Aussenden von Licht mittels der Lichtquelle einer Sensorvorrichtung gemäß einem der Ansprüche 8 bis 10,
    - Detektieren der lateralen Position eines von dem Objekt relektierten Lichtstrahls mittels des optoelektronischen Sensors (41) der Sensorvorrichtüng, und
    - Berechnen des Abstandes zwischen der Sensorvorrichtung und dem Objekt aus der lateralen Position des reflektierten Lichtstrahls.

**14.** Computerprogramm, das alle Schritte des Verfahrens nach Anspruch 13 ausführt, wenn es auf einem Rechengerät abläuft.

**Claims**

**1.** Optoelectronic sensor (41), wherein at least one first layer (411) is applied on the surface of the receiving component in the optical detection plane, said first layer (411) being formed as an optically effective aperture, **characterised in that** the aperture is formed as a dot array with laterally increasing or decreasing density.

**2.** Optoelectronic sensor according to claim 1, **characterised in that** the optical detection plane is a surface region of the optoelectronic sensor, which is configured exclusively to generate a photocurrent.

**3.** Optoelectronic sensor according to claim 1 or 2, **characterised in that** the first layer (411) is a metallic layer which is applied to the optoelectronic sensor (41) by means of a metallisation process.

**4.** Optoelectronic sensor according to claim 3, **characterised in that** the aperture has a maximum structure width of 0.2 mm.

**5.** Optoelectronic sensor according to one of claims 1 to 4, **characterised in that** at least one second layer (412) is arranged on the at least one first layer (411), said second layer (412) being impermeable for light with a wavelength in a specific range of the optical spectrum.

**6.** Optoelectronic sensor according to one of claims 1 to 4, **characterised in that** at least one glass wafer is arranged on the at least one first layer.

**7.** Optoelectronic sensor according to one of claims 1 to 6, **characterised in that** the optoelectronic sensor (41) is a sensor which detects a lateral displacement of the intensity focal point of incident light on the optical position sensor, wherein the optoelectronic sensor is selected in particular from the group consisting of a PSD element, a CCD line and a photodiode.

**8.** Sensor device, comprising a light source and an optoelectronic sensor (41) according to one of claims 1 to 7.

**9.** Sensor device according to claim 8, **characterised in that** the sensor device is selected from the group consisting of a light sensor, a retroreflective sensor, a time-of-flight sensor and a colour sensor.

**10.** Sensor device according to claim 8 or 9, **characterised in that** the light source is selected from the group consisting of a light diode, a laser diode and a laser.

**11.** Sensor device according to one of claims 8 to 10, **characterised in that** it comprises an adjusting element, which is configured to adjust the switch point of the optoelectronic sensor to an object.

**12.** Sensor device according to one of claims 8 to 10, **characterised in that** the optoelectronic sensor (41) is connected to an amplifier circuit, which effects a constant amplification or a continuous amplification.

**13.** Method for position detection of an object, comprising

    - emitting light by means of the light source of a sensor device according to one of claims 8 to 10,
    - detecting the lateral position of a light beam reflected by the object by means of the optoelectronic sensor (41) of the sensor device,
    - calculating the distance between the sensor device and the object from the lateral position of the reflected light beam.

**14.** Computer program that carries out all steps of the method according to claim 13 when it runs on a computing device.


**Revendications**

**1.** Capteur optoélectronique (41), dans lequel au moins une première couche (411) servant de diaphragme à effet optique est appliquée sur la surface de l'élément récepteur dans le plan de détection optique, **caractérisé en ce que** le diaphragme est conçu sous la forme d'un ensemble de points dont la densité augmente ou diminue latéralement.

**2.** Capteur optoélectronique selon la revendication 1, **caractérisé en ce que** le plan de détection optique consiste en une zone de la surface du capteur optoélectronique agencé exclusivement pour la production d'un courant photoélectrique.

**3.** Capteur optoélectronique selon la revendication 1 ou 2, **caractérisé en ce que** la première couche (411) consiste en une couche métallique ayant été appliquée sur le capteur optoélectronique (41) au moyen d'un procédé de métallisation.

**4.** Capteur optoélectronique selon la revendication 3, **caractérisé en ce que** le diaphragme présente une largeur structurelle de 0,2 mm maximum.

**5.** Capteur optoélectronique selon l'une des revendications 1 à 4, **caractérisé en ce qu'**au moins une deuxième couche (412), imperméable à la lumière d'une longueur d'onde située dans une certaine plage du spectre optique, est disposée sur l'au moins une première couche (411).

**6.** Capteur optoélectronique selon l'une des revendications 1 à 4, **caractérisé en ce qu'**au moins une plaquette de verre est disposée sur l'au moins une première couche.

**7.** Capteur optoélectronique selon l'une des revendications 1 à 6, **caractérisé en ce que** le capteur optoélectronique (41) consiste en un capteur détectant un décalage latéral du barycentre d'intensité de la lumière incidente sur le capteur de position optique, le capteur optoélectronique étant notamment choisi dans le groupe constitué par un élément PSD, une barrette CCD et une photodiode.

**8.** Dispositif à capteur, comprenant une source de lumière et un capteur optoélectronique (41) selon l'une des revendications 1 à 7.

**9.** Dispositif à capteur selon la revendication 8, **caractérisé en ce que** le dispositif à capteur est choisi dans le groupe constitué par un détecteur photosensible, un barrage optique à réflexion, un capteur de temps de propagation et un capteur de couleurs.

**10.** Dispositif à capteur selon la revendication 8 ou 9, **caractérisé en ce que** la source de lumière est choisie dans le groupe constitué par une diode électroluminescente, une diode laser et un laser.

**11.** Dispositif à capteur selon l'une des revendications 8 à 10, **caractérisé en ce qu'**elle comprend un élément de réglage conçu pour ajuster le point de commutation du capteur optoélectronique sur un objet.

**12.** Dispositif à capteur selon l'une des revendications 8 à 10, **caractérisé en ce que** le capteur optoélectronique (41) est relié à un circuit redresseur assurant un redressement constant ou un redressement continu.

**13.** Procédé de reconnaissance de la position d'un objet, comprenant

    - l'émission de lumière au moyen de la source de lumière d'un dispositif à capteur selon l'une des revendications 8 à 10,
    - la détection de la position latérale d'un faisceau lumineux réfléchi par l'objet, au moyen du capteur optoélectronique (41) du dispositif à capteur, et

- le calcul de la distance séparant le dispositif à capteur et l'objet à partir de la position latérale du faisceau lumineux réfléchi.

**14.** Programme informatique effectuant toutes les étapes du procédé selon la revendication 13 lorsqu'il est exécuté sur un appareil informatique.

Fig. 1

Fig. 2

36

35

3

34

33

32

31

**Fig. 3**

43

42

4

412

411

41

**Fig. 4**

**Fig. 5**

**Fig. 6**

Fig. 7

Fig. 8

**Fig. 9**

**Fig. 10**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6285832 B1
- DE 69803044 T2
- US 20020051068 A1
- US 20090065884 A1
- US 20080283948 A1